# NEW EUROPEAN PATENT SPECIFICATION

(11) **EP 2 183 608 B2**
(45) Date of publication and mention of the opposition decision: **06.04.2022**
(45) Mention of the grant of the patent: 06.06.2018
(21) Application number: 08709950.3
(22) Date of filing: 31.01.2008
(51) Int. Cl.: G01R 31/12, G01R 31/14

(54) **INSTRUMENT AND A METHOD FOR DETECTING PARTIAL ELECTRICAL DISCHARGES OCCURRING IN AN ELECTRIC APPARATUS**
INSTRUMENT UND VERFAHREN ZUM DETEKTIEREN VON IN EINER ELEKTRISCHEN VORRICHTUNG AUFTRETENDEN ELEKTRISCHEN TEILENTLADUNGEN
INSTRUMENT ET PROCÉDÉ PERMETTANT DE DÉTECTER DES DÉCHARGES ÉLECTRIQUES PARTIELLES SE PRODUISANT DANS UN APPAREIL ÉLECTRIQUE

(30) Priority: 26.07.2007 IT PR20070061
(43) Date of publication of application: 12.05.2010
(73) Proprietor: Techimp HQ S.R.L., 40069 Zola Predosa (BO) (IT)
(72) Inventor: MONTANARI, Gian Carlo, 40069 ZOLA PREDOSA (Bologna) (IT); CAVALLINI, Andrea, 40033 CASALECCHIO DI RENO (Bologna) (IT); PASINI, Gaetano, I-41054 Marano Sul Panaro (Modena) (IT)
(74) Representative: Conti, Marco
(86) International application number: PCT/IB2008/050371
(87) International publication number: WO 2009/013640

(56) References cited:
- EP-A- 0 813 282
- EP-A2- 1 094 323
- WO-A-2006/122415
- US-B1- 6 313 640
- A. OBRALIC et al.: "Verbesserte Zustandsbewertung durch neue Auswerteverfahren bei der Synchronen Mehrstellen-TE-Messung an Hochspannungsmaschinen", Diagnostik elektrischer Betriebsmittel, 20 September 2006 (2006-09-20), Berlin Offenbach ISBN: 3-8007-2977-6
- R. HOLLE et al.: "Typprüfung eines digitalen TE-Messsystems nach IEC 60270", Diagnostik elektrischer Betriebsmittel, 20 September 2006 (2006-09-20), Berlin Offenbach ISBN: 3-8007-2977-6
- "Diagnostik elektrischer Betriebsmittel", ETG Fachberichts 104, 20 September 2006 (2006-09-20), pages 5-11,

## Description

The present invention relates to an instrument and a method for detecting partial electrical discharges occurring in an electric apparatus.

The technical field of the present invention is that of the diagnostics of electrical systems (in particular in high voltage), through the detection / processing of partial electric discharges and possibly other quantities.

Note that a partial discharge is an electric discharge that involves a limited portion of an insulator of an electrical system, therefore it does not cause the immediate failure of the system, but rather its progressive degradation. Thus, partial discharges have, by their nature, a development that is substantially limited to a defect of the insulating system. In this light, the diagnostic techniques based on the detection and interpretation of partial discharges are among the most promising and they are widely studied within scientific research, because the study of partial discharges enables to investigate the nature of the defect of the insulating system in which the discharges occur.

However, the detection together with the subsequent assessment of the partial discharges for diagnostic purposes is not yet completely included among industrial standards, as an instrument for planning the maintenance and/or replacement of electrical components operating at high voltage, because of the difficulty encountered in interpreting the results of the measurements.

With regard to the detection of partial discharges, various types of techniques have been developed, exploiting the different physical phenomena associated with the onset of the discharges, e.g. optical, acoustic and electrical techniques. The present invention relates, in particular but not exclusively, to the electrical detection techniques, which consist, as is well known, of measuring the current impulses that travel through a detection circuit coupled with the electrical system to be examined. Such detected current impulses (hereafter called discharge impulses, for the sake of simplicity) have a time development, which depends on the dynamics with which the partial discharges take place (i.e. on the physics of the discharge phenomena) and on the nature of the media which the detected pulses traverse, in their path from the discharge site (in which the discharges originate) to the detection site. Thus, the time development of the discharge impulses, consisting of the wave form of the impulses themselves, comprises valuable information from the diagnostic viewpoint, with regard both to the physical phenomena associated to the discharges (correlated to the nature of the defects of the insulating system), and the nature of the medium which the detected pulses traverse (correlated to the location of the defects within the insulating system).

With regards to the difficulties in the interpretation of the results of the partial discharge measurements, they depend, in addition to the need to have a specific experience and case record available, on the fact that the measured data may be found to be unreliable and not significant.

It is possible that in the detection of the signals associated to the partial discharges there may be a loss of essential information for a subsequent assessment of the signals for diagnostic purposes (a loss of information can be constituted, for example, by a missed detection of an impulse, or by a missed detection of the wave form of an impulse).

Considering that discharge impulses contain information that can be exploited diagnostically, it would be particularly important to detect the impulses with a particular broad detection bandwidth, e.g. in the order of tens of MHz, or at least of some MHz.

However, it should be noted that the signals that are detected are current impulses, which are correlated to the charge transfers taking place in the defects of the electrical apparatus and constituting the partial discharges, but they do not constitute a direct measurement of said charge transfers.

Therefore, to be able to estimate the intensity of a partial discharge corresponding to a detected signal, it is necessary to calibrate the acquisition instrument, aimed at determining a proportionality factor between the amplitude of the signals measured by the instrument and the charge transfer associated to the partial discharges corresponding to those signals.

To this end, a calibrator able to inject into the apparatus a current impulse with suitable characteristics is applied to terminals of the apparatus; in particular, the calibrator is such as to generate the current impulse that would be generated by a transfer of a predetermined quantity of charge between said terminals. Therefore, a value of apparent charge equal to said predetermined charge value is attributed to a signal detected by the apparatus corresponding to the current impulse injected by the calibrator. The ratio between the predetermined apparent charge value and the value of the amplitude of the detected signal constitutes the sought calibration factor. Therefore, to the discharge signals detected on an electrical apparatus are associated corresponding values of apparent charge by multiplying the amplitudes of said signals times the calibration factor previously determined for that apparatus undergoing calibration.

In this light, it should be noted that the amplitude of the detected signals and the attribution to said signals of corresponding values of apparent charge is influenced by the width of the detection band.

Therefore, it should be noted that the signals detected by instruments having a particularly broad detection band cannot be compared in terms of amplitude with the signals detected on the same apparatus by instruments with reduced detection band, even though each instrument has been calibrated.

In fact, the standard IEC 60270 sets specifications for detection instruments in order to make the results of the measurements comparable and consistent.

Thus, this standard defines the characteristics of the instruments for PD measurements and it also defines how to test their performance.

In particular, said standard establishes certain characteristics for the pass band or bandwidth of the detection instruments; the standard suggests that the lower cut-off frequency (f1) is between 30 and 100 kHz, that the upper cut-off frequency (f2) is less than 500 kHz and the bandwidth value (f2-f1) is between 100 and 400 kHz, said frequency values measured at an attenuation of 6 dB relative to band centre. Consistently, the standard states that instruments provided with particularly broad detection band (higher than a few MHz) cannot be calibrated in compliance with the standard.

Therefore, on one hand, there is the need to use a detection instrument with the broadest possible detection band, to enable subsequent diagnostic assessments (for example, to be able to discern the shapes of the impulses of the discharges from interference signals or to separate signals related to discharge occurring in different discharge sites); on the other hand, there is the need to use an instrument with a limited detection band, to quantify the signals detected in compliance with the standard.

In this light, known solutions provide for the use of instruments with broad band or, alternatively, with limited band. In some cases, one uses in parallel or in succession two instruments, one with broad band and the other with limited band, but with no possibility to compare the results obtained in compliance with the standard, and with evident expenditure in terms of time and costs.

The problem of the simultaneous measurement of the impulses in broad band (to preserve information useful for diagnostic assessment) and in narrow band (to attribute to the signals a value of amplitude in pC that is compliant with the standard, i.e. comparable with the results of other instruments) can also be solved using two different acquisition channels for the same signal: the first one constituted by a broad band channel, the second one constituted by a channel with narrow band hardware analogue filter.

In this case, however, there are some problems and disadvantage. In the first place, it is necessary to use an additional, slower A/D converter (e.g. 10 MS/s instead of 100 MS/s for the channel with limited band). Moreover, there is the problem of being able to establish a correspondence between the impulses acquired by the two channels (because the analogue filter delays the signal).

Additionally, the band of the narrow band channel is not susceptible to any kind of adjustment, because it is defined via hardware. Therefore, this solution is substantially equivalent to the solution of placing two detection instruments in parallel with each other. Prior art documents WO2006/122415, EP0813282, and US6313640 teach partial discharge detection apparatus. The object of the present invention is to eliminate the aforesaid drawbacks and to make available an instrument and a method for detecting partial electrical discharges which are particularly reliable and effective, having a particularly broad detection band and having the possibility to attribute apparent charge values to said signals in accordance with the standard.

Said object is fully achieved by the apparatus of the present invention, which is characterised by the content of the appended claims. In particular, said apparatus comprises a processing stage connected both to the input stage and to the output stage to receive said digital signal and to transfer to the output stage a filtered digital signal equivalent to a digital representation of said analogue signal, generated by an input stage with predetermined detection band with a value of less than 500 kHz.

The method according to the present invention in particular comprises the following steps:
- detecting an analogue signal representative of one or more partial discharge impulses and generating a digital signal representative of the entire wave form of said one or more impulses with a detection bandwidth of at least 2 MHz;
- processing said digital signal to generate a filtered digital signal equivalent to a digital representation of said analogue signal generated by an input stage with predetermined detection band in accordance with the specifications of the IEC 60270 Standard, i.e. with a value substantially smaller than 500 kHz;
- transferring, at the output from the instrument, data in digital form pertaining both to said digital signal and to the filtered digital signal.

These and other features shall become more readily apparent from the description that follows of a preferred embodiment, illustrated purely by way of non limiting example in the accompanying drawing tables, in which:

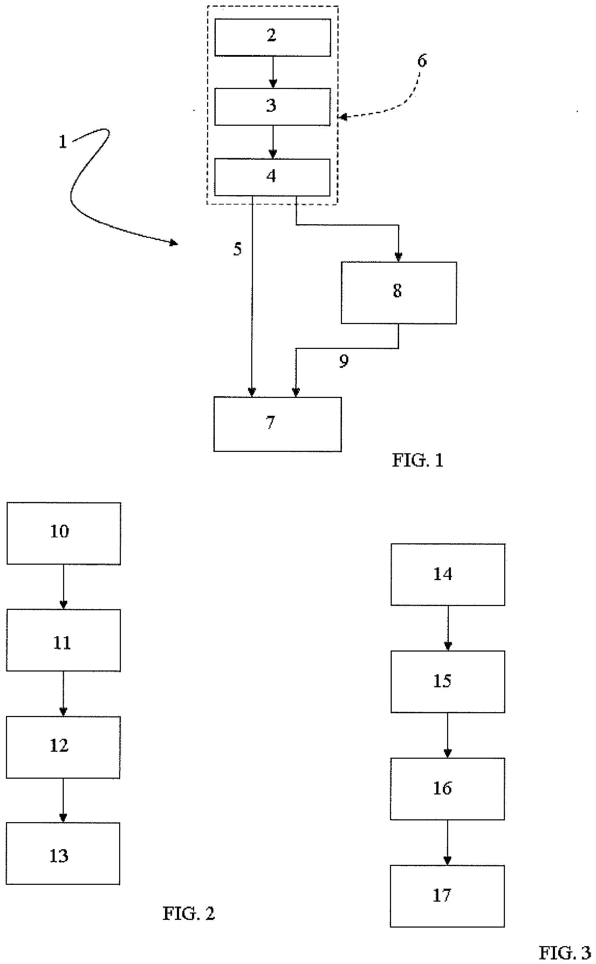

figure 1 schematically shows an apparatus according to the present invention;
figure 2 schematically shows a method for calibrating the apparatus of figure 1 that does not fall under the scope of the claims;
figure 3 schematically shows a method according to the present invention.

In the figures, the reference number 1 designates an instrument for detecting partial electrical discharges occurring in an electric apparatus.

The instrument 1 comprises:
- a sensor 2 (of a substantially known kind) that can be coupled to the apparatus for generating an analogue signal representative of an impulse (or multiple impulses) correlated to a partial discharge occurring in the apparatus;
- a conditioning unit 3 connected to the sensor 2 to receive said analogue signal;
- a digitalisation unit 4 connected to the conditioning unit 3 to receive a conditioned analogue signal and make available at the output a digital signal 5 representative of the entire wave form of said impulse.

The conditioning unit carries out an amplification of the analogue signal received from the sensor and an analogue filtering aimed at avoiding aliasing phenomena (according to a substantially known technique).

The sensor 2, the conditioning unit 3 and the digitalisation unit 4 define an input stage 6 of the instrument 1.

Therefore, said input stage 6 is adapted to receive the analogue signal representative of (at least) one impulse correlated to a partial discharge and to generate said digital signal 5 at the output.

The sensor 2, the conditioning unit 3 and the digitalisation unit 4 are designed to detect the signal with a detection band width of at least 2 MHz (according to a substantially known technique).

Therefore, said input stage 5 defines a detection band width or bandwidth of at least 2 MHz.

Preferably, said detection band width is at least 20 MHz. More preferably, said detection band width is at least 200 MHz. The detection band width can advantageously exceed 1 GHz.

The instrument 1 further comprises an output stage 7 connected to the input stage 6 (or to the digitalisation unit 4) to receive said digital signal 6.

The output stage 7 is adapted to transfer data in digital form at the output of the instrument 1.

Therefore, the instrument 1 makes available the entire wave form of each discharge impulse acquired in broad band.

Moreover, the apparatus 1 originally comprises a processing stage 8 connected both to the input stage 6 (or to the digitalisation unit 4) and to the output stage 7 to receive the digital signal 5, process it and transfer to the output stage 7 a filtered digital signal 9 equivalent to a digital representation of said analogue signal generated by an input stage 6 with predetermined detection band width of less than 500 kHz.

In other words, the processing stage 8 transfers to the output stage 7 a filtered digital signal 9 equivalent to the digital representation of said analogue signal which the input stage would generate if a predetermined detection band width of a value below 500 kHz were defined (by the imput stage itself).

Therefore, the instrument 1, for each signal detected in broad band, makes available a corresponding digitally filtered signal that has equivalent characteristics to those which the same signal detected by an instrument with limited band width in predetermined fashion would have.

Thus, the processing stage 8 digitally produces the effects of an acquisition instrument having at its input a band-pass analogue filter such as to limit the band width in predetermined fashion (in particular, in accordance with the standard).

In particular, said predetermined band defines:
- a lower cut-off frequency of between 30 kHz and 100 kHz;
- a higher cut-off frequency of less than 500 kHz;
- a width between 100 kHz and 400 kHz.

The processing stage 8 comprises a tuneable digital filter, so that said filtered digital signal is equivalent to a digital representation of said analogue signal generated by an input stage with desired detection band.

Therefore, the tuneable digital filter enables to obtain a filtered digital signal 9 corresponding to a desired detection band, variable at will according to specific needs, in addition to the digital signal 5 detected in broad band.

This advantageously enables to suit the characteristics of the instrument to the type of an apparatus being assessed and to the interference and background noise present during the measurements.

With regard to the implementation modes of the digital filter of the processing unit 8, four embodiments are provided (however, they are not to be construed as limiting). A first embodiment of the digital filter consist of a fourth order Butterworth digital filter, with pass bands at -6 dB equal to the values of f1 and f2 in the intervals described above.

A second embodiment of the digital filter is based on a spectral analysis performed by means of the DFT (or more preferably FFT) algorithm; i.e., the sampled signal is transformed from the time domain to the frequency domain using the DFT (or FFT) algorithm, the band of interest is selected (as a function of the f1 and f2 values described above) eliminating all undesired spectral components and the anti-transform is performed returning the signal to the time domain.

Means are also provided for windowing the acquired signal in the time domain, e.g. by means of Hamming, or Hanning, or Bartlett windows.

Therefore, in the second embodiment the digital filter comprises:
- means for transforming the digital signal 5 from the time domain to the frequency domain;
- means for selecting a portion of said transformed signal corresponding to a desired frequency interval;
- means for anti-transforming said selected portion of the transformed signal from the frequency domain to the time domain.

In the third embodiment, two digital filters are cascaded, one high-pass (with cut-off frequency at -6 dB corresponding to desired values of f1) followed by a low-pass (with cut-off frequency at -6 dB corresponding to desired values of f2), e.g. of the fourth order (but not necessarily) Butterworth type (but not necessarily).

Therefore, in the third embodiment the digital filter comprises a first high pass digital filter and a second low pass digital filter mutually connected in cascade fashion.

A fourth embodiment of the digital filter consists of a fourth order FIR digital filter. Moreover, some characteristics of the instrument 1 are unchanged with respect to the different embodiments, i.e.:
- the dynamics of the A/D conversion system must be at least equal to 14 bit;
- the duration of the detection of a signal (constituted by the number of acquired samples multiplied times the sampling time interval) must be greater than (at least twice) the reciprocal of the value of f1 (i.e. the value of the lower cut-off frequency of the digital filter).

Note also that the "zero padding" technique is to be used, i.e. increasing the duration of the detection of a signal by an arbitrary time adding samples with zero value to the vector of the acquired ones.

Note that the digital filter of the processing unit 8 (to ensure that it makes available a filtered digital signal 9 that is actually equivalent to a signal detected with a limited band width in accordance with the standard) is such as to define a module of the transfer impedance of the digital filter (ratio between voltage output from the filter and input current) as a function of the frequency, with predetermined value.

For this purpose, a "fictitious" output of the implemented digital filter is defined (displayed and/or recorded) to be used to verify said transfer impedance as a function of frequency.

Moreover, the output stage 7 comprises a module for selecting a plurality of segments corresponding to partial discharge impulses within the digital signal 5 and a similar module for selecting a plurality of segments corresponding to partial discharge impulses within the filtered digital signal 9. Said selection modules comprise triggering means, known in themselves.

Moreover, the output stage 7 comprises a module for correlating the digital signal 5 to the filtered digital signal 9, to associate to each selected segment within the digital signal 5 a corresponding selected signal within the filtered digital signal 9, so that each pair of correlated segments corresponds to a same partial discharge impulse.

The correlation module comprises means for synchronising the triggering means active on the digital signal 5 and on the filtered digital signal 9; said synchronisation means compute any time delays introduced by the processing module 8 on the filtered digital signal 9. In this regard, note that the digital signal 5 and the filtered digital signal 9 define corresponding continuous data streams.

An additional technical feature shared by all the embodiments described above is that the processing unit 8 originally comprises a module for conditioning the digital signal (corresponding to a triggered impulse) inserted immediately upstream of the digital filter.

Said conditioning module comprises three operative unit as described below.

A first operative unit of the conditioning module comprises means for deriving an instant of actual start of the impulse, based on the instant of activation of the trigger and on the corresponding level of the trigger itself.

A second operative unit of the conditioning module comprises means for assessing the trend of the impulse in a time interval immediately following the instant of actual start derived in the first phase, to attribute a sign (positive or negative) to the impulse; in particular, the sign attributed to the impulse is positive or negative according to whether said trend is increasing or decreasing, respectively.

A third operative unit of the conditioning module comprises means for comparing the amplitude of the impulse portion corresponding to the sign attributed to the impulse to the one corresponding to the remaining portion (or the portion of impulse corresponding to the sign opposite the one attributed to the impulse).

A fourth operative unit comprises means for zeroing the impulse portion corresponding to the opposite polarity to the one attributed (by zeroing the samples constituting said signal portion, e.g. with the known technique of "zero padding"), as a function of the outcome of the comparison carried out by the second operative unit.

In particular, if the amplitude of the impulse portions corresponding to the respective signs have similar value, the impulse is transmitted without variations to the digital filter positioned downstream of the conditioning module; otherwise, if the amplitude of the impulse portion corresponding to the sign attributed to the impulse is significantly greater than (e.g. at least twice) the amplitude of the other portion, then said portion (or the one corresponding to the sign opposite the one attributed to the impulse) is entirely zeroed; the signal thus conditioned is then transmitted to the digital filter.

The action of the conditioning module has the effect of improving (i.e. reducing) the standard deviation of the impulses transmitted to the digital filter, thereby advantageously enabling to make particularly stable the numerical indication at the output of the digital signal. Therefore, the conditioning module enables to make the instrument according to the invention particularly precise and rugged.

A substantial advantage of the present invention consists of the possibility of acquiring the impulse in broad band, thereby being able to process it to determine values of parameters linked to the wave form of the impulse, important from the diagnostic viewpoint and, simultaneously, to make available at the output an information (about the amplitude of the partial discharge) that is comparable and consistent with the detection made with different instruments (with any detection band).

It is important to stress that the transfer of the digital signal 5, which is a representation of discharge impulses detected in broad band, is transferred to the output stage 7 simultaneously with the filtered digital signal 9, which is a representation of the same discharge impulses in a different band, that can be defined / adjusted at will.

Another important advantage of the present invention consists of the ability to modify the values of f1 and f2 at will as a function of the environmental measurement conditions, to obtain the best signal/noise ratio.

The present disclosure also makes available a method for calibrating an instrument for detecting partial electrical discharges occurring in an electric apparatus, wherein said method does not fall under the scope of the claims.

Said calibration method originally comprises the following steps.
- applying 10 to terminals of the apparatus a current impulse corresponding to an impulse generated in the apparatus by a transfer between said terminals of an electric charge of a predetermined value;
- detecting 11 an analogue signal, representative of said current impulse, and generating a digital signal representative of the entire wave form of said one or more impulses with a detection band width of at least 2 MHz;
- processing 12 said digital signal to generate a filtered digital signal equivalent to a digital representation of said analogue signal generated by an input stage with predetermined detection band with a value of less than 500 kHz;
- deriving 13 a calibration factor defined by a ratio between said predetermined value of electric discharge and a peak voltage value of said filtered digital signal. Therefore, the present invention also makes available a method for detecting partial electrical discharges occurring in an electric apparatus.

Said detection method originally comprises the following steps.
- detecting 14 an analogue signal, representative of one or more partial discharge signals, and generating a digital signal representative of the entire wave form of said one or more impulses with a detection band width of at least 2 MHz;
- processing 15 said digital signal to generate a filtered digital signal equivalent to a digital representation of said analogue signal generated by an input stage with predetermined detection band with a value of less than 500 kHz;
- transferring 16, at the output from the instrument, data in digital form pertaining both to said digital signal and to the filtered digital signal.

With regard to the detection step, preferably each individual partial discharge impulse (or each digital signal 5) is acquired for at least 50 microseconds, in order to have sufficient information for the subsequent processing step.

This enables, advantageously, to reduce the effect of environmental noise on the processing step.

Preferably, step of detecting the analogue signal and generating the digital signal defines a detection band width of at least 20 MHz.

In particular, the processing step 15 comprises a digital filtering step, with the possibility of adjustment in such a way that said filtered digital signal is equivalent to a digital representation of said analogue signal generated by an input stage with detection band width of a desired value.

Said digital filter provides for the use of a digital filter implemented according to different embodiment variants, as described above.

In particular, said digital filtering step comprises a fourth order Butterworth digital filtering.

Alternatively, the digital filtering step comprises the following steps:
- transforming said digital signal from the time domain to the frequency domain;
- selecting a portion of said transformed signal corresponding to a desired frequency interval;
- anti-transforming said selected portion of the transformed signal from the frequency domain to the time domain.

Alternatively, the digital filtering step comprises the following steps, mutually arranged in cascade:
- high pass digital filtering;
- low pass digital filtering;

Alternatively, the digital filtering step comprises a fourth order FIR digital filtering. Note also that, originally, the processing step 15 further comprises, preliminarily to the digital filtering step, a step of digital conditioning of the triggered impulse.

Said conditioning step comprises the four steps in succession described below.

A first step (of the conditioning step) provides for deriving an instant of actual start of the impulse, based on the instant of activation of the trigger and on the corresponding level of the trigger.

A second step (of the conditioning step) provides for assessing the trend of the impulse in a time interval immediately subsequent to the instant of actual start derived in the first step, to attribute to the impulse a (positive or negative) sign; in particular, the sign attributed to the impulse is positive or negative depending on whether said trend is growing or diminishing, respectively.

A third step (of the conditioning step) provides for comparing the amplitude of the impulse portion corresponding to the sign attributed to the impulse in the second step to the amplitude corresponding to the remaining portion (or the portion of impulse corresponding to the sign opposite the one attributed to the impulse).

A fourth step (of the conditioning step) provides for a possible zeroing of the impulse portion corresponding to the polarity opposite to the one attributed in the third step, depending on the outcome of the comparison carried out by the second operative unit.

In particular, if the amplitudes of the impulse portions corresponding to the respective signs have similar value, the impulse is transmitted without variations to the digital filter positioned downstream of the conditioning module.

Otherwise, if the amplitude of the impulse portion corresponding to the sign attributed to the impulse is significantly greater than (e.g. at least twice) the amplitude of the other portion, then said portion (or the one corresponding to the opposite sign to the one attributed to the impulse) is entirely zeroed, i.e. the samples constituting said signal portion are zeroed (e.g. with the technique known as "zero padding"); the signal thus conditioned is then transmitted to the digital filter.

The action of the conditioning step has the effect of improving (i.e. reducing) the standard deviation of the impulses transmitted to the digital filter, thereby advantageously enabling to make particularly stable the numerical indication at the output of the digital signal. Therefore, the conditioning step enables to make the instrument according to the invention particularly precise and rugged.

Moreover, the method according to the present invention originally comprises a step of attributing 17 to said digital signal an apparent charge value given by the product between a peak voltage value of the filtered digital signal and a calibration factor obtained with the calibration method described above.

## Claims

1. An instrument (1) for detecting partial electrical discharges occurring in an electric apparatus, comprising:
- an input stage (6) set up to receive an analogue signal representative of an impulse correlated to a partial discharge and to generate at the output a digital signal (5) representative of the entire wave form of said impulse, said input stage (6) defining a detection band width of at least 2 MHz;
- an output stage (7) connected to the input stage (6) to receive said digital signal (5) and set up to transfer data in digital form at the output from the instrument (1),
**characterised in that** it comprises a processing stage (8) connected both to the input stage (6) and to the output stage (7) to receive and process said digital signal (5) and transfer to the output stage a filtered digital signal (9) equivalent to a digital representation of said analogue signal generated by an input stage with predetermined detection bandwidth of less than 500 kHz, the output stage (7) being connected to the input stage (6) and to the processing stage (8) such as to receive simultaneously said digital signal (5) from the input stage (6) and said filtered digital signal (9) from the processing stage (8), wherein the output stage (7) comprises a module for correlating selected segments from the digital signal (5) to corresponding selected segments from the filtered digital signal (9), so that each pair of correlated segments corresponds to a same detected partial discharge impulse.

2. An instrument machine as claimed in claim 1, wherein the input stage (6) comprises:
- a sensor (2) that can be coupled to the apparatus for generating an analogue signal representative of an impulse correlated to a partial discharge;
- a conditioning unit (3) connected to the sensor to receive said analogue signal;
- a digitalisation unit (4) connected to the conditioning unit to receive a conditioned analogue signal and make available at the output said digital signal (5).

3. An instrument as claimed in claim 1 wherein the input stage (6) defines a detection band width of at least 20 MHz.

4. An instrument as claimed in any of the previous claims, wherein the processing stage (8) defines said predetermined detection bandwidth having:
- a lower cut-off frequency (f1) of between 30 kHz and 100 kHz;
- a higher cut-off frequency (f2) of between 100 kHz and 500 kHz;
- a width between 100 kHz and 400 kHz.

5. An instrument as claimed in any of the previous claims, wherein the processing stage (8) comprises a tuneable digital filter, so that said filtered digital signal (9) is equivalent to a digital representation of said analogue signal (5) generated by an input stage with detection bandwidth of a desired value.

6. An instrument as claimed in claim 5, wherein said digital filter comprises:
- means for transforming said digital signal from the time domain to the frequency domain;
- means for selecting a portion of said transformed signal corresponding to a desired frequency interval;
- means for anti-transforming said selected portion of the transformed signal from the frequency domain to the time domain.

7. An instrument as claimed in claim 5, wherein said digital filter comprises a first high pass digital filter and a second low pass digital filter mutually connected in cascade fashion.

8. An instrument as claimed in claim 5, wherein the processing stage (8) comprises a module for conditioning the digital signal representative of the impulse, inserted upstream of the digital filter and comprising:
- means for deriving an instant of actual start of the impulse;
- means for attributing a sign to the impulse according to the trend of the impulse in a time interval immediately subsequent to said instant of actual start of the impulse;
- means for the possible zeroing of the impulse portion corresponding to the polarity opposite to the one attributed to the impulse, as a function of a comparison between the amplitude of said portion and that of the portion corresponding to the attributed polarity.

9. A method for detecting partial electrical discharges occurring in an electric apparatus, **characterised in that** it comprises the following steps:
- detecting (14) an analogue signal representative of one or more partial discharge signals, and generating a digital signal (5) representative of the entire wave form of said one or more impulses with a detection bandwidth of at least 2 MHz;
- processing (15) said digital signal to generate a filtered digital signal (9) equivalent to a digital representation of said analogue signal generated by an input stage with predetermined detection bandwidth of less than 500 kHz;
- selecting segments from the digital signal (5) and from the filtered digital signal (9), said segments being related to partial discharge impulses;
- correlating the segments selected from the digital signal (5) with corresponding segments selected from the filtered digital signal (9), so that each pair of correlated segments corresponds to a same detected partial discharge impulse;
- transferring (16), at the output from the instrument, data in digital form pertaining both to said digital signal (5) and to the filtered digital signal (9).

10. A method as claimed in claim 9, wherein said predetermined detection band defines:
- a lower cut-off frequency of between 30 kHz and 100 kHz;
- a higher cut-off frequency of between 100 kHz and 500 kHz;
- a width between 100 kHz and 400 kHz.

11. A method as claimed in any of the claims 9 through 10, wherein the processing step (15) comprises a digital filtering step, with the possibility of adjustment in such a way that said filtered digital signal (9) is equivalent to a digital representation of said analogue signal generated by an input stage with detection band width of a desired value.

12. A method as claimed in claim 11, wherein said digital filtering step comprises the following steps:
- transforming said digital signal from the time domain to the frequency domain;
- selecting a portion of said transformed signal corresponding to a desired frequency interval;
- anti-transforming said selected portion of the transformed signal from the frequency domain to the time domain.

13. A method as claimed in claim 11, wherein said digital filtering step comprises the following cascaded steps:
- high pass digital filtering;
- low pass digital filtering.

14. A method as claimed in claim 11, wherein the processing step (15) comprises a digital conditioning step, preliminary to the digital filtering step and comprising the following steps:
- deriving an instant of actual start of the impulse;
- attributing a sign to the impulse according to the trend of the impulse in a time interval immediately subsequent to said instant of actual start of the impulse;
- possible zeroing of the impulse portion corresponding to the polarity opposite to the one attributed to the impulse, as a function of a comparison between the amplitude of said portion and that of the portion corresponding to the attributed polarity.

## Patentansprüche

1. Instrument (1) zum Detektieren von in einer elektrischen Vorrichtung auftretenden elektrischen Teilentladungen, umfassend:
- eine Eingangsstufe (6), die dazu eingerichtet ist, ein Analogsignal zu empfangen, das einen mit einer Teilentladung verknüpften Impuls darstellt, und am Ausgang ein Digitalsignal (5) zu generieren, das die gesamte Wellenform des Impulses darstellt, wobei die Eingangsstufe (6) eine Erkennungsbandbreite von mindestens 2 MHz definiert;
- eine Ausgangsstufe (7), die mit der Eingangsstufe (6) verbunden ist, um das Digitalsignal (5) zu empfangen und die dazu eingerichtet ist, Daten in digitaler Form am Ausgang vom Instrument (1) zu übertragen, **dadurch gekennzeichnet, dass** es eine Verarbeitungsstufe (8) umfasst, die sowohl mit der Eingangsstufe (6) als auch mit der Ausgangsstufe (7) verbunden ist, um das Digitalsignal (5) zu empfangen und zu verarbeiten und an die Ausgangsstufe ein gefiltertes Signal (9) zu übermitteln, das mit einer digitalen Darstellung des Analogsignals gleichwertig ist, das von einer Eingangsstufe generiert wird, mit einer vorgegebenen Erkennungsbandbreite von weniger als 500 kHz, wobei die Ausgangsstufe (7) mit der Eingangsstufe (6) und der Verarbeitungsstufe (8) verbunden ist, sodass sie gleichzeitig das Digitalsignal (5) von der Eingangsstufe (6) und das gefilterte Digitalsignal (9) von der Verarbeitungsstufe (8) empfängt, wobei die Ausgangsstufe (7) ein Modul umfasst, um ausgewählte Segmente vom Digitalsignal (5) mit entsprechenden ausgewählten Segmenten vom gefilterten Digitalsignal (9) zu korrelieren, sodass ein jedes Paar korrelierter Segmente einem selben erfassten Teilentladungsimpuls entspricht.

2. Instrumentenmaschine nach Anspruch 1, wobei die Eingangsstufe (6) umfasst:
- einen Sensor (2), der mit der Vorrichtung zum Generieren eines Analogsignals, das einen Impuls darstellt, der mit einer Teilentladung verknüpft ist, gekuppelt werden kann;
- eine Aufbereitungseinheit (3), die mit dem Sensor verbunden ist, um das Analogsignal zu empfangen;
- eine Digitalisierungseinheit (4), die mit der Aufbereitungseinheit verbunden ist, um ein aufbereitetes Analogsignal zu empfangen und das Digitalsignal (5) am Ausgang bereitzustellen.

3. Instrument nach Anspruch 1, wobei die Eingangsstufe (6) eine Erkennungsbandbreite von wenigstens 20 MHz definiert.

4. Instrument nach einem der vorhergehenden Ansprüche, wobei die Verarbeitungsstufe (8) die vorgegebene Erkennungsbandbreite definiert, aufweisend:
- eine niedrigere Abschaltfrequenz (f1) zwischen 30 kHz und 100 kHz;
- eine höhere Abschaltfrequenz (f2) zwischen 100 kHz und 500 kHz;
- eine Breite zwischen 100 kHz und 400 kHz.

5. Instrument nach einem der vorhergehenden Ansprüche, wobei die Verarbeitungsstufe (8) einen abstimmbaren Digitalfilter umfasst, sodass das gefilterte Digitalsignal (9) mit einer digitalen Darstellung des Analogsignals (5) gleichwertig ist, das durch eine Eingangsstufe mit einer Erkennungsbandbreite eines gewünschten Werts generiert wurde.

6. Instrument nach Anspruch 5, wobei der Digitalfilter umfasst:
- Mittel zum Umwandeln des Digitalsignals von der Zeitdomäne in die Frequenzdomäne;
- Mittel zum Auswählen eines Abschnitts des umgewandelten Signals, entsprechend einem gewünschten Frequenzintervall;
- Mittel zur Rückumwandlung des ausgewählten Abschnitts des umgewandelten Signals von der Frequenzdomäne in die Zeitdomäne.

7. Instrument nach Anspruch 5, wobei der Digitalfilter einen ersten digitalen Hochpass-Filter und einen zweiten digitalen Tiefpass-Filter umfasst, die gegenseitig auf Kaskadenweise miteinander verbunden sind.

8. Instrument nach Anspruch 5, wobei die Verarbeitungsstufe (8) ein Modul umfasst, um das den Impuls darstellende Digitalsignal aufzubereiten, eingefügt stromaufwärts des Digitalfilters und umfassend:
- Mittel zum Ableiten eines Augenblicks des tatsächlichen Impulsstarts;
- Mittel, um dem Impuls ein Zeichen zuzuordnen nach dem Impulstrend eines Zeitintervalls, das unmittelbar auf den Augenblick des tatsächlichen Impulsstarts folgt;
- Mittel zur möglichen Nullstellung des Impulsabschnitts entsprechend der Polarität, entgegengesetzt zu der, die dem Impuls zugeordnet wurde, als eine Funktion eines Vergleichs zwischen der Amplitude des Abschnitts und der des Abschnitts entsprechend der zugeordneten Polarität.

9. Verfahren zum Detektieren von in einer elektrischen Vorrichtung auftretenden elektrischen Teilentladungen, **dadurch gekennzeichnet, dass** es folgende Schritte umfasst:
- Detektieren (14) eines Analogsignals, das repräsentativ für ein oder mehrere Teilentladungssignale ist, und Generieren eines Digitalsignals (5), das repräsentativ für die gesamte Wellenform des einen oder der mehreren Impulse mit einer Erkennungsbandbreite von mindestens 2 MHz ist;
- Verarbeiten (15) des Digitalsignals, um ein gefiltertes Digitalsignal (9) zu generieren, das mit einer digitalen Darstellung des Analogsignals gleichwertig ist, das von einer Eingangsstufe generiert wird, mit einer vorgegebenen Erkennungsbandbreite von weniger als 500 kHz;
- Auswählen von Segmenten vom Digitalsignal (5) und dem gefilterten Digitalsignal (9), wobei sich die Segmente auf Teilentladungsimpulse beziehen;
- Korrelieren der vom Digitalsignal (5) ausgewählten Segmente mit entsprechenden, vom gefilterten Digitalsignal (9) ausgewählten Elementen, sodass ein jedes Paar korrelierter Segmente einem selben erfassten Teilentladungsimpuls entspricht;
- Übertragen (16) am Ausgang vom Instrument von Daten in digitaler Form, die sowohl dem Digitalsignal (5) als auch dem gefilterten Digitalsignal (9) angehören.

10. Verfahren nach Anspruch 9, wobei die vorgegebene Erkennungsbandbreite Folgendes definiert:
- eine niedrigere Abschaltfrequenz zwischen 30 kHz und 100 kHz;
- eine höhere Abschaltfrequenz zwischen 100 kHz und 500 kHz;
- eine Breite zwischen 100 kHz und 400 kHz.

11. Verfahren nach einem der Ansprüche 9 bis 10, wobei der Schritt zum Verarbeiten (15) einen Schritt zum digitalen Filtern umfasst, mit der Möglichkeit einer Einstellung, sodass das gefilterte Digitalsignal (9) gleichwertig ist mit einer digitalen Darstellung des Analogsignals, generiert durch eine Eingangsstufe mit einer Erkennungsbandbreite eines gewünschten Werts.

12. Verfahren nach Anspruch 11, wobei der Schritt zum digitalen Filtern die folgenden Schritte umfasst:
- Umwandeln des Digitalsignals von der Zeitdomäne in die Frequenzdomäne;
- Auswählen eines Abschnitts des umgewandelten Signals, entsprechend einem gewünschten Frequenzintervall;
- Rückumwandlung des ausgewählten Abschnitts des umgewandelten Signals von der Frequenzdomäne in die Zeitdomäne.

13. Verfahren nach Anspruch 11, wobei der Schritt zum digitalen Filtern hintereinander die folgenden Schritte umfasst:
- digitale Hochpass-Filterung;
- digitale Tiefpass-Filterung.

14. Verfahren nach Anspruch 11, wobei der Schritt zum Verarbeiten (15) einen Schritt zum digitalen Aufbereiten umfasst, der vor dem Schritt zum digitalen Filtern stattfindet und die folgenden Schritte umfasst:
- Ableiten eines Augenblicks des tatsächlichen Impulsstarts;
- dem Impuls ein Zeichen zuordnen nach dem Impulstrend eines Zeitintervalls, das unmittelbar auf den Augenblick des tatsächlichen Impulsstarts folgt;
- mögliche Nullstellung des Impulsabschnitts entsprechend der Polarität, entgegengesetzt zu der, die dem Impuls zugeordnet wurde, als eine Funktion eines Vergleichs zwischen der Amplitude des Abschnitts und der des Abschnitts entsprechend der zugeordneten Polarität.

## Revendications

1. Instrument (1) permettant de détecter des décharges électriques partielles se produisant dans un appareil électrique, comprenant :
- un étage d'entrée (6) prévu pour recevoir un signal analogique représentatif d'une impulsion corrélée à une décharge partielle et pour générer à la sortie un signal numérique (5) représentatif de la forme d'onde entière de ladite impulsion, ledit étage d'entrée (6) définissant une bande passante de détection d'au moins 2 MHz ;
- un étage de sortie (7) raccordé à l'étage d'entrée (6) pour recevoir ledit signal numérique (5) et prévu pour transférer des données sous forme numérique à la sortie à partir de l'instrument (1), **caractérisé en ce qu'**il comprend un étage de traitement (8) raccordé à la fois à l'étage d'entrée (6) et à l'étage de sortie (7) pour recevoir et traiter ledit signal numérique (5) et transférer vers l'étage de sortie un signal numérique filtré (9) équivalent à une représentation numérique dudit signal analogique généré par un étage d'entrée avec une bande passante de détection prédéterminée de moins de 500 kHz, l'étage de sortie (7) étant raccordé à l'étage d'entrée (6) et à l'étage de traitement (8) de manière à recevoir simultanément ledit signal numérique (5) de l'étage d'entrée (6) et ledit signal numérique filtré (9) de l'étage de traitement (8), dans lequel l'étage de sortie (7) comprend un module servant à corréler des segments sélectionnés à partir du signal numérique (5) à des segments correspondants sélectionnés à partir du signal numérique filtré (9) de sorte que chaque paire de segments corrélés corresponde à une même impulsion de décharge partielle détectée.

2. Instrument selon la revendication 1, dans lequel l'étage d'entrée (6) comprend :
- un capteur (2) pouvant être couplé à l'appareil pour générer un signal analogique représentatif d'une impulsion corrélée à une décharge partielle ;
- un appareil de conditionnement (3) raccordé au capteur pour recevoir ledit signal analogique ;
- un appareil de numérisation (4) raccordé à l'appareil de conditionnement pour recevoir un signal analogique conditionné et rendre disponible ledit signal numérique (5) à la sortie.

3. Instrument selon la revendication 1, dans lequel l'étage d'entrée (6) définit une bande passante de détection d'au moins 20 MHz.

4. Instrument selon l'une quelconque des revendications précédentes, dans lequel l'étage de traitement (8) définit ladite bande passante de détection prédéterminée comportant :
- une fréquence de coupure inférieure (f1) comprise entre 30 et 100 kHz ;
- une fréquence de coupure supérieure (f2) comprise entre 100 et 500 kHz ;
- une largeur comprise entre 100 et 400 kHz.

5. Instrument selon l'une quelconque des revendications précédentes, dans lequel l'étage de traitement (8) comprend un filtre numérique pouvant être syntonisé, de sorte que ledit signal numérique filtré (9) soit équivalent à une représentation numérique dudit signal analogique (5) généré par un étage d'entrée avec la bande passante de détection d'une valeur désirée.

6. Instrument selon la revendication 5, dans lequel ledit filtre numérique comprend :
- des moyens servant à transformer ledit signal numérique du domaine temporel au domaine fréquentiel ;
- des moyens pour sélectionner une partie dudit signal transformé correspondant à un intervalle de fréquence désiré ;
- des moyens servant à anti-transformer ladite partie sélectionnée du signal transformé du domaine fréquentiel au domaine temporel.

7. Instrument selon la revendication 5, dans lequel ledit filtre numérique comprend un premier filtre numérique passe-haut et un second filtre numérique passe-bas mutuellement raccordés en cascade.

8. Instrument selon la revendication 5, dans lequel l'étage de traitement (8) comprend un module, pour conditionner le signal numérique représentatif de l'impulsion, inséré en amont du filtre numérique et comprenant :
- des moyens servant à déduire un moment du début réel de l'impulsion ;
- des moyens pour attribuer un signe à l'impulsion selon la tendance de l'impulsion dans un intervalle de temps suivant immédiatement ledit moment du début réel de l'impulsion ;
- des moyens pour la possible remise à zéro de la partie d'impulsion correspondant à la polarité opposée à celle attribuée à l'impulsion en fonction d'une comparaison entre l'amplitude de ladite partie et celle de la partie correspondant à la polarité attribuée.

9. Procédé permettant de détecter des décharges électriques partielles se produisant dans un appareil électrique, **caractérisé en ce qu'**il comprend les étapes suivantes :
- détecter (14) un signal analogique, représentatif d'un ou plusieurs signaux de décharge partielle, et générer un signal numérique (5) représentatif de la totalité de la forme d'onde desdites une ou plusieurs impulsions avec une bande passante de détection d'au moins 2 MHz ;
- traiter (15) ledit signal numérique pour générer un signal numérique filtré (9) équivalant à une représentation numérique dudit signal analogique généré par un étage d'entrée avec une bande passante de détection de moins de 500 kHz ;
- sélectionner des segments à partir du signal numérique (5) et à partir du signal numérique filtré (9), lesdits segments étant liés à des impulsions de décharges partielles ;
- corréler les segments sélectionnés à partir du signal numérique (5) avec des segments correspondants sélectionnés à partir d'un signal numérique filtré (9), de sorte que chaque paire de segments corrélés corresponde à une même impulsion de décharge partielle détectée ;
- transférer (16), à la sortie de l'instrument, des données sous forme numérique relatives à la fois audit signal numérique (5) et au dit signal numérique filtré (9) .

10. Procédé selon la revendication 9, dans lequel ladite bande de détection définit :
- une fréquence de coupure inférieure comprise entre 30 et 100 kHz ;
- une fréquence de coupure supérieure comprise entre 100 et 500 kHz ;
- une largeur comprise entre 100 et 400 kHz.

11. Procédé selon l'une quelconque des revendications de 9 à 10, dans lequel l'étape de traitement (15) comprend une étape de filtrage numérique avec la possibilité de réglage de manière à ce que ledit signal numérique filtré (9) soit équivalent à une représentation numérique dudit signal analogique généré par un étage d'entrée avec la bande passante de détection d'une valeur désirée.

12. Procédé selon la revendication 11, dans lequel ladite étape de filtrage numérique comprend les étapes suivantes :
- transformer ledit signal numérique du domaine temporel au domaine fréquentiel ;
- sélectionner une partie dudit signal transformé correspondant à un intervalle de fréquence désiré ;
- anti-transformer ladite partie sélectionnée du signal transformé du domaine fréquentiel au domaine temporel.

13. Procédé selon la revendication 11, dans lequel ladite étape de filtrage numérique comprend les étapes en cascade suivantes :
- filtrage numérique passe-haut ;
- filtrage numérique passe-bas.

14. Procédé selon la revendication 11, dans lequel l'étape de traitement (15) comprend une étape de conditionnement numérique, préliminaire à l'étape de filtrage numérique et comprenant les étapes suivantes :
- déduire un moment du début réel de l'impulsion ;
- attribuer un signe à l'impulsion selon la tendance de l'impulsion dans un intervalle de temps suivant immédiatement ledit moment du début réel de l'impulsion ;
- possible remise à zéro de la partie d'impulsion correspondant à la polarité opposée à celle attribuée à l'impulsion en fonction d'une comparaison entre l'amplitude de ladite partie et celle de la partie correspondant à la polarité attribuée.
